# EUROPÄISCHE PATENTSCHRIFT

(11) **EP 2 269 218 B1**
(45) Veröffentlichungstag und Bekanntmachung des Hinweises auf die Patenterteilung: **29.03.2017**
(21) Anmeldenummer: 08874103.8
(22) Anmeldetag: 22.12.2008
(51) Int. Cl.: H01L 23/40, H01L 25/07, H01L 23/051

(54) **KÜHLANORDNUNG MIT ZWEI NEBENEINANDER ANGEORDNETEN HALBLEITERBAUELEMENTEN**
COOLING ARRANGEMENT COMPRISING TWO SEMICONDUCTOR COMPONENTS DISPOSED NEXT TO ONE ANOTHER
DISPOSITIF DE REFROIDISSEMENT COMPORTANT DEUX COMPOSANTS À SEMI-CONDUCTEURS DISPOSÉS CÔTE À CÔTE

(30) Priorität: 29.04.2008 AT 6632008
(43) Veröffentlichungstag der Anmeldung: 05.01.2011
(73) Patentinhaber: Siemens Aktiengesellschaft, 80333 München (DE)
(72) Erfinder: GLATZL, Andreas, A-2000 Stockerau (AT)
(74) Vertreter: Maier, Daniel Oliver
(86) Internationale Anmeldenummer: PCT/EP2008/068147
(87) Internationale Veröffentlichungsnummer: WO 2009/132723

(56) Entgegenhaltungen:
- EP-A- 0 376 478
- EP-A- 1 494 278
- GB-A- 1 384 951
- SU-A1- 1 576 940
- US-A- 3 652 903
- US-A- 4 591 896
- US-A- 5 168 425
- US-A- 6 107 711
- US-A1- 2006 138 452

## Beschreibung

Die Erfindung betrifft eine Kühlanordnung, umfassend zwei nebeneinander angeordnete, scheibenförmige Halbleiterbauelemente, insbesondere Thyristoren, mit zueinander ungefähr parallel ausgerichteten Symmetrieachsen, welche mittels nur einer Spannvorrichtung zwischen zwei Kühlkörpereinheiten gespannt sind.

Halbleiterbauelemente erzeugen im Betrieb Wärme, die abgeführt werden muss, um eine Überhitzung mit einem damit verbunden Leistungsabfall bis hin zur Zerstörung zu vermeiden. Dies gilt vor allem für Leistungs-Halbleiterbauelemente, welche für hohe Ströme ausgelegt sind.

Um eine ausreichende Wärmeabfuhr sicherzustellen, werden Leistungs-Halbleiterbauelemente in der Regel scheibenförmig ausgebildet. Die beiden voneinander abgewandten Kreisflächen bilden dabei die elektrischen Kontaktflächen und sind gegen zwei Kühlkörpereinheiten spannbar. Die Kühlkörpereinheiten sind thermisch und elektrisch mit dem Halbleiterbauelement verbunden und umfassen demnach geeignete Anschlüsse zur Kontaktierung innerhalb eines Schaltungsaufbaus.

Eine ausreichend große Spannkraft ist notwendig, um einen flächigen Kontakt zwischen dem Halbleiterbauelement und den Kühlkörpern sicherzustellen. Ein nur punktueller Kontakt würde den Wärmeübergang zwischen den in Kontakt befindlichen Flächen beeinträchtigen.

Insbesondere Thyristoren zur Phasenanschnittsteuerung höher Wechselströme oder Drehströme werden scheibenförmig ausgebildet. Hochleistungsthyristoren werden dabei mit Kräften von bis zu 100 kN zwischen zwei Kühlkörpereinheiten verspannt, um einen ausreichenden Wärmeübergang sicherzustellen. Diese Spannkraft wird in der Regel vom Hersteller eines Halbleiterbauelements in engen Grenzen vorgegeben, um einen störungsfreien Betrieb mit der angegebenen Nennleistung zu ermöglichen.

Nach dem Stand der Technik kennt man Spannvorrichtungen, mittels derer mehrere scheibenförmige Halbleiterbauelemente gemeinsam mit Kühlkörpereinheiten verspannt werden. Derartige Spannvorrichtungen sind aus der US 6 107 711 und aus der EP 0 376 478 bekannt.

Beispielsweise offenbart die DE 40 25 885 A1 eine Kühlanordnung, bei der mehrere Halbleiterbauelemente zwischen mehreren Kühlkörpereinheiten mit einer gemeinsamen Symmetrieachse stapelförmig verspannt werden. Um zwei Halbleiterbauelemente innerhalb dieses Stapels parallel zu schalten, ist es notwendig, zumindest zwei Kühlkörpereinheiten elektrisch zu verbinden.

Zur einfachen Parallelschaltung zweier Halbleiterbauelemente kennt man deshalb auch Spannvorrichtungen, innerhalb derer die Halbleiterbauelemente nebeneinander mit im Wesentlichen zueinander parallel ausgerichteten Symmetrieachsen angeordnet sind. Die beidseitig gegen die Halbleiterbauelemente gepressten Kühlkörpereinheiten schließen dabei die Halbleiterbauelemente zu einer Parallelschaltung bzw. zu einer Antiparallelschaltung zusammen. Eine derartige Anordnung ist beispielsweise aus der DE 32 23 532 A1 bekannt.

Eine Kühlanordnung gemäß dem Oberbegriff des Anspruchs 1 ist aus der US 3 652 903 bekannt.

Beim gemeinsamen Verspannen zweier nebeneinander angeordneter Halbleiterbauelemente müssen die Maßtoleranzen der Halbleiterbauelemente und der Spannvorrichtung berücksichtigt werden, um die in engen Grenzen vorgegebene Spannkraft für beide Halbleiterbauelemente sicherzustellen. Nach dem Stand der Technik umfasst eine Spannvorrichtung zu diesem Zweck wenigstens ein Federelement, insbesondere eine Blattfeder. Das Federelement ist in der Weise angeordnet, dass einstellbare Federkräfte in den beiden Symmetrieachsen der Halbleiterbauelemente wirken.

Somit erfordern derartige Vorrichtungen einerseits eine genaue Auslegung der Federkräfte und andererseits eine aufwendige Montage, um die Halbleiterbauelemente mit den Kühlkörpereinheiten in beiden Symmetrieachsen gleichmäßig mit den vorgegeben Kräften zu verspannen.

Der Erfindung liegt die Aufgabe zugrunde, die aus dem Stand der Technik bekannten Kühlvorrichtungen für nebeneinander angeordnete Halbleiterbauelemente weiterzubilden.

Diese Aufgabe wird durch die im kennzeichnenden Teil des Anspruchs 1 angegebenen Merkmale gelöst.

Die Spannkräfte in den beiden Symmetrieachsen werden durch die Bestandteile der Spannvorrichtung aufgebracht, wobei die in den Zugankern wirken Zugkräfte über die Druckplatten und die punktförmigen Auflagen gleichmäßig auf die beiden in den Symmetrieachsen der Halbleiterbauelementen wirkenden Spannkräfte übertragen werden. Die Schwächung des Querschnitts bzw. die Teilung der einen Kühlkörpereinheit im Bereich zwischen den beiden Halbleiterbauelementen bewirkt einen Ausgleich der Maßtoleranzen der Halbleiterbauelemente. Die eine Kühlkörpereinheit ist dabei in zwei gleichmäßig steife Abschnitte unterteilt, wobei jeder dieser Abschnitte die jeweils über eine punktförmige Auflage eingeleitete Spannkraft auf ein Halbleiterbauelement überträgt. Im Falle einer geteilten Kühlkörpereinheit sind die beiden Abschnitte zur Parallelschaltung bzw. Antiparallelschaltung der Halbleiterbauelemente elektrisch zu verbinden.

Für den Maßtoleranzausgleich ist es ausreichend, wenn nur eine der Kühlkörpereinheiten einen geschwächten Querschnitt oder eine Teilung im Bereich zwischen den Halbleiterbauelementen aufweist. Es ist jedoch erforderlich, dass diese eine Kühlkörpereinheit über die angegeben punktförmigen Auflagen gegen eine Druckplatte gedrückt ist. Die Schwächung des Querschnitts erfolgt im einfachsten Fall durch einen Schlitz auf der den Halbleiterbauelementen abgewandten Seite der einen Kühlkörpereinheit.

Neben dem einfachen Ausgleich der Maßtoleranzen hat die erfindungsgemäße Kühlanordnung den Vorteil, dass kein Federelement zur Aufbringung der Spannkraft notwendig ist. Stattdessen wird eine ausreichend hohe und genaue Spannkraft in beiden Symmetrieachsen durch das Zusammenwirken aller Elemente der Spannvorrichtung bereitgestellt, insbesondere durch die Spannungen in der ersten Druckplatte und in den Zugankern.

Vorteilhaft ist es, wenn die beiden Halbleiterbauelemente antiparallel geschaltet sind. Bei Verwendung zweier Thyristoren ist dann beispielsweise eine einfach aufgebaute Phasenanschnittsteuerung realisierbar. Dabei wird an jeder Kühlkörpereinheit eine Stromschiene angebracht, wobei eine Stromschiene über Sicherungen an einen Wechselstromleiter und die andere Stromschiene über einen zu steuernden Verbraucher mit einem Nullleiter verbunden ist.

In einer einfachen Ausprägung der Erfindung ist die eine Kühlkörpereinheit aus einem im Wesentlichen quaderförmigen Kühlkörper gebildet, welcher zur Schwächung des Querschnitts einen Schlitz aufweist. Ein derartiger Kühlkörper ist einfach herzustellen und bietet eine ausreichende Kühlfunktion für einfache Anwendungen. Günstigerweise ist der Kühlkörper aus Aluminium gefertigt.

Eine andere einfache Ausprägung sieht vor, dass die eine Kühlkörpereinheit aus zwei im Wesentlichen quaderförmigen Kühlkörpern mit einer elektrischen Verbindung ausgebildet ist und dass jeweils ein Kühlkörper mit einem Halbleiterbauelement kontaktiert ist.

Für höhere Anforderungen an die Kühlfunktion ist es vorteilhafte, wenn die eine Kühlkörpereinheit aus einem im Wesentlichen quaderförmigen Kühlkörper mit Längsrippen und einer auf den Längrippen aufliegenden Abschlussplatte gebildet ist und dass zur Schwächung des Querschnitts ein Schlitz quer durch die Längsrippen geführt ist, welcher auch die Abschlussplatte zweiteilt. Die Längsrippen vergrößern die Wärmeabgabefläche des Kühlkörpers und bilden mit der Abschlussplatte Kühlkanäle zur Realisierung einer erzwungenen Konvektion. Die geteilte Abdeckplatte dient zudem der Übertragung der punktförmig eingeleiteten Spannkraft auf die Längsrippen des Kühlkörpers.

Der zur Schwächung des Querschnitts im Bereich zwischen den Halbleiterbauelementen vorgesehene Schlitz reicht günstigerweise über die gesamte Rippenhöhe, sodass der Beitrag der Rippen zum Widerstandsmoment des Querschnitts im Schlitz entfällt. Maßtoleranzen der Halbleiterbauelemente werden somit durch die Verformung der Kühlkörpereinheit im Bereich des Schlitzes ausgeglichen, sodass eine gleichmäßige Spannkraftverteilung auf beide Halbleiterbauelemente sichergestellt ist.

Zur einfachen Ausbildung einer punktförmigen Auflage ist es von Vorteil, wenn auf der den Halbleiterbauelementen abgewandten Seite der einen Kühlkörpereinheit im Bereich der beiden Symmetrieachsen Erhebungen, insbesondere Kugelkalotten, zur Bildung der punktförmigen Auflagen angeordnet sind. Diese können beispielsweise durch Auftragsschweißen oder durch Einpressen zweier Stahlkugeln in die Oberfläche der Kühlkörpereinheit gebildet werden.

Eine andere Ausbildung der punktförmigen Auflage sieht vor, dass zwischen der einen Kühlkörpereinheit und der ersten Druckplatte im Bereich der beiden Symmetrieachsen jeweils eine Scheibe mit einer zentrischen Kugelkalotte zur Bildung der punktförmigen Auflagen angeordnet ist. Derartige Scheiben sind im Handel erhältlich, sodass kein eigener Fertigungsschritt zur Herstellung der punktförmigen Auflagen erforderlich ist.

Für Anwendung mit geringen Anforderungen hinsichtlich Spannkraft und Wärmeabfuhr ist es zudem günstig, wenn zur Vereinfachung der Fertigung und der Montage die andere Kühlkörpereinheit und die zweite Druckplatte einstückig ausgebildet sind.

Ansonsten ist es von Vorteil, wenn die andere Kühlkörpereinheit aus einem im Wesentlichen quaderförmigen Kühlkörper mit Längsrippen und einer auf den Längrippen aufliegenden Abschlussplatte gebildet ist. Die Kühlkörper der beiden Kühlkörpereinheiten können dann bis auf den Schlitz in dem einen Kühlkörper baugleich ausgeführt werden, wodurch wiederum die Fertigung der Bauteile vereinfacht wird.

Die Erfindung wird nachfolgend in beispielhafter Weise unter Bezugnahme auf die beigefügten Figuren erläutert. Es zeigen in schematischer Darstellung:
- Fig. 1: Explosionszeichnung einer Kühlanordnung
- Fig. 2: Aufriss der Kühlanordnung gemäß Fig. 1
- Fig. 3: Schnittdarstellung der Kühlanordnung mit der in Fig. 2 angegebenen Schnittführung

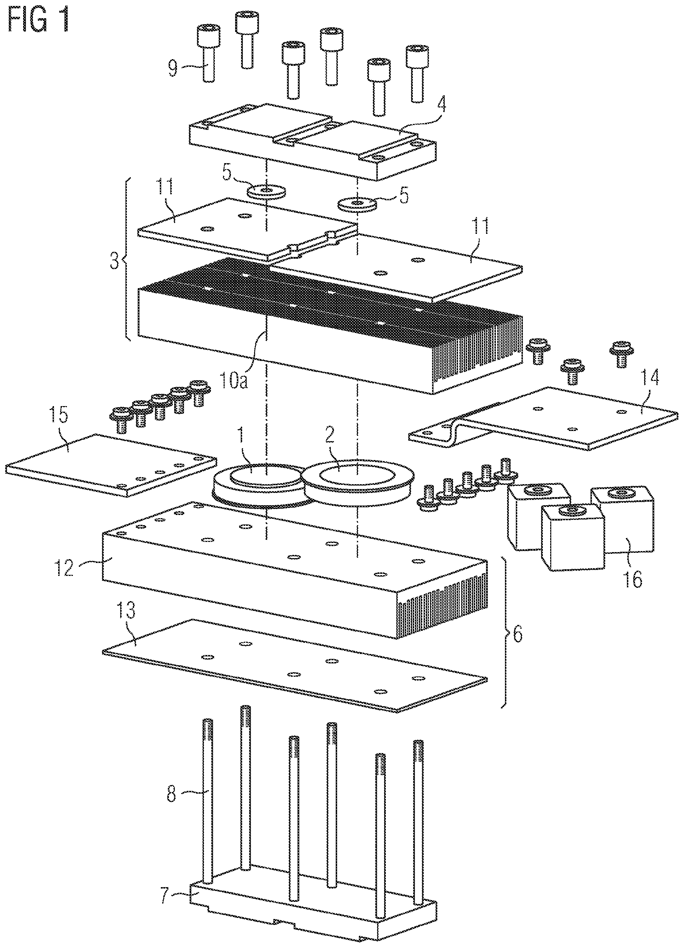

Die in Fig. 1 dargestellte Kühlanordnung umfasst zwei antiparallel geschaltete Halbleiterbauelemente 1 und 2, welche beispielsweise als Thyristoren ausgebildet sind. Diese scheibenförmigen Halbleiterbauelemente 1, 2 sind nebeneinander zwischen zwei Kühlkörpereinheiten 3 und 6 angeordnet, wobei die Symmetrieachsen der Halbleiterbauelemente 1, 2 parallel verlaufen. Die eine Kühlkörpereinheit 3 umfasst einen Kühlkörper 10 mit Längsrippen, d.h. die Rippen verlaufen auf der den Halbleiterbauelementen 1, 2 abgewandten Seite parallel zu einer durch die beiden Symmetrieachsen der Halbleiterbauelemente 1, 2 aufgespannten Ebene. Im Bereich zwischen den Halbleiterbauelementen 1, 2 sind die Längsrippen mit einem Schlitz 10a unterbrochen. Der Schlitz 10a verläuft in Fig. 1 entlang einer gedachten Spiegelebene der Symmetrieachsen der Halbleiterbauelemente 1, 2 und reicht über die gesamte Höhe der Längsrippen. Der Schlitz 10a kann auch in anderer Weise geführt sein, beispielsweise in einer gegenüber den Symmetrieachsen der Halbleiterbauelemente 1, 2 geneigten Ebene. Die Anordnung des Schlitzes 10a soll so gewählt werden, dass seine Projektion auf die Kontaktebene der Kühlkörpereinheit 3 mit den Halbleiterbauelementen 1, 2 im montierten Zustand zwischen den beiden Kontaktflächen der Kühlkörpereinheit 2 mit den Halbleiterbauelementen 1, 2 verläuft.

Auf der den Halbleiterbauelementen 1, 2 abgewandten Seite des Kühlkörpers 10 umfasst die eine Kühlkörpereinheit 3 eine zweigeteilte Abdeckplatte 11. Die Teilung der Abdeckplatte 11 verläuft im montierten Zustand entlang des Schlitzes 10a des Kühlkörpers 10, also in Fig. 1 entlang der gedachten Spiegelebene der Symmetrieachsen der Halbleiterbauelemente 1, 2. Die Abdeckplatte 11 verschließt im montierten Zustand die oberen Öffnungen zwischen den Längsrippen des Kühlkörpers 10, wodurch zwischen den Längsrippen geschlossen Kühlkanäle 10b zur Realisierung einer erzwungenen Konvektion, z.B. mittels eines Gebläses, ausgebildet sind.

Die Abdeckplatte 11 dient zudem der Aufnahme der punktförmig eingeleiteten Spannkräfte, die über Scheiben mit jeweils einer zentrischen Kugelkalotte als punktförmige Auflage 5 von einer ersten Druckplatte 4 auf die eine Kühlkörpereinheit 3 übertragen werden. Die Kugelkalotten sind in den Symmetrieachsen der Halbleiterbauelemente 1, 2 angeordnet. Die Teilung der Abdeckplatte 11 und der Spalt 10a des Kühlkörpers 10 teilen die Kühlkörpereinheit 3 in zwei Abschnitte mit Querschnitten, welche ein größeres Widerstandsmoment als der Querschnitt im Bereich des Spalts 10a bzw. der Teilung aufweisen. Die Teilung der einen Kühlkörpereinheit 3 ermöglicht somit eine minimale Relativverschieben der beiden in sich steifen Abschnitte in Richtung der Symmetrieachsen der Halbleiterbauelemente 1, 2 zum Ausgleich einer Maßtoleranz der Scheibendicken dieser Halbleiterbauelemente 1, 2.

Alternativ zu der in Fig. 1 dargestellten Anordnung kann zur punktförmigen Krafteinleitung die Abdeckplatte selbst bzw. ein rippenloser Kühlkörper Erhöhungen im Bereich der Symmetrieachsen der Halbleiterbauelemente 1, 2 aufweisen. Dabei entfällt die Montage und somit das Einrichten der in Fig. 1 dargestellten Scheiben zur Bildung der punktförmigen Auflagen 5.

Erfindungsgemäß sind die zwei Halbleiterbauelemente 1, 2 gegen zwei Kühlkörpereinheiten 3, 6 gespannt, wobei die andere Kühlkörpereinheit 6 in Fig. 1 einen Kühlkörper 12 und eine Abdeckplatte 13 umfasst. Dieser Kühlkörper 12 weist ebenfalls Längsrippen zur verbesserten Konvektion auf, jedoch ohne Schlitz. Auch die Abdeckplatte ist ohne Teilung aufgeführt, weil eine Kühlkörpereinheit 3 mit geschwächtem Querschnitt zwischen den Halbleiterbauelementen 1, 2 zum Ausgleich der Toleranzen derselben ausreicht.

Die andere Kühlkörpereinheit 6 ist im montierten Zustand flächig gegen eine zweite Druckplatte 7 gespannt. Die Abdeckplatte 13 dient nur zur Ausbildung geschlossener Kühlkanäle und ist deshalb dünner als die geteilte Abdeckplatte 11 der einen Kühlkörpereinheit 3 ausführbar.

Die zweite Druckplatte 7 ist mit Zugankern 8 verbunden, die im montierten Zustand parallel zu den Symmetrieachsen der Halbleiterbauelemente 1, 2 durch die Kühlanordnung geführt sind und mit entsprechenden Befestigungsmittel 9 die erste Druckplatte 4 gegen die zweite Druckplatte 7 verspannen. Günstigerweise sind die Zuganker 8 mit der zweiten Druckplatte 7 verschweißt, um mit geringem Montageaufwand eine gute Kraftübertragung sicherzustellen.

Die Zuganker 8 sind beispielsweise aus einem Rundmaterial gefertigt, wobei an den losen Enden Gewinde zur Befestigung von als Muttern ausgebildeten Befestigungsmittel 9 vorgesehen sind.

Wie in Fig. 1 dargestellt, ist es zum gleichmäßigen Verspannen günstig, an jedem Eck der Kühlanordnung jeweils einen Zuganker 8 und zwischen den Halbleiterbauelementen 1, 2 zwei Zuganker 8 vorzusehen. Die Zuganker 8 zwischen den Halbleiterbauelementen 1, 2 sind günstigerweise in der Spiegelebene der beiden Symmetrieachsen der Halbleiterbauelemente 1, 2 angeordnet.

Zur Durchführung der Zuganker 8 sind die Kühlkörpereinheiten 3, 6 mit entsprechenden Bohrungen versehen. Auch die erste Druckplatte 4 weist Bohrungen zur Durchführung der Zuganker 8 auf, wobei die Zuganker 8 im montierten Zustand mit den Gewinden über die Oberfläche der ersten Druckplatte hinausragen.

Die erste Druckplatte 4 ist über die eine Kühlkörpereinheit 3 mit den dieser Kühlkörpereinheit 3 zugewandten Kontaktflächen der Halbleiterbauelemente 1, 2 elektrisch kontaktiert. Die Zuganker 8 sind über die zweite Druckplatte 7 und die andere Kühlkörpereinheit 6 mit den anderen Kontaktflächen der Halbeiterbauelemente 1, 2 elektrisch kontaktiert. Um einen Kurzschluss zuwischen den voneinander abgewandten Kontaktflächen der Halbleiterbauelemente 1, 2 zu vermeiden, müssen einerseits die Bohrungen zur Durchführung der Zuganker 8 in der einen Kühlkörpereinheit 3 und in der ersten Druckplatte 4 ausreichend groß sein und andererseits die Befestigungselemente 9 gegenüber der ersten Drückplatte 4 isoliert sein. Zu diesem Zweck sind beispielsweise die als Muttern ausgebildeten Befestigungselemente 9 mit Kunststoffhülsen gegenüber den Auflageflächen auf der ersten Druckplatte 4 isoliert. Diese Kunststoffhülsen reichen günstigerweise mit einem entsprechend dimensionierten Teil in die Bohrungen der einen Kühlkörpereinheit 3, um den erforderlichen Isolationsabstand zwischen den Zugankern 8 und den Bohrungsmantelflächen sicherzustellen.

Im Bereich der Symmetrieachsen der Halbleiterbauelemente 1, 2 können die Druckplatten 4, 7 zur Versteifung eine größere Dicke aufweisen. Das Material und die Dicke der ersten Druckplatte 4 bestimmen ebenso wie das Material und der Querschnitt der Zuganker 8 die mögliche Verspannkraft. Günstigerweise sind die Druckplatten 4, 7 und die Zuganker 8 sowie die Befestigungsmittel 9 aus Stahl zur Erzielung einer hohen Verspannkraft bis ca. 100 kN je Halbleiterbauelement 1, 2 gefertigt.

Die elektrischen Kontakte der Halbeiterbauelemente sind über Stromschienen 14, 15 nach außen geführt. Dabei ist eine erste Stromschiene 14 mittels geeigneter Befestigungsmittel elektrisch mit der einen Kühlkörpereinheit 3 verbunden. Zu diesem Zweck ist beispielsweise die eine Kühlkörpereinheit 3 an einer Stirnseite verlängert um eine Auflagefläche zur Anbringung der Stromschiene 14 zu schaffen. Die andere Kühlkörpereinheit 6 ist auf der gegengleichen Stirnseite zur Anbringung der zweiten Stromschiene 15 verlängert. Diese Anordnung der Stromschienen 14, 15 hat den Vorteil, dass die Verbindungen zwischen den Stromschienen 14, 15 und den Kühlkörpereinheiten 3, 6 unbeeinflusst von den infolge des Verspannens auftretenden Relativbewegungen innerhalb der Kühlanordnung bleiben. In Fig. 1 sind des Weiteren Sicherungen 16 dargestellt, über welcher die erste Stromschiene 14 an die Phase eines Wechselspannungsnetzes anschließbar ist.

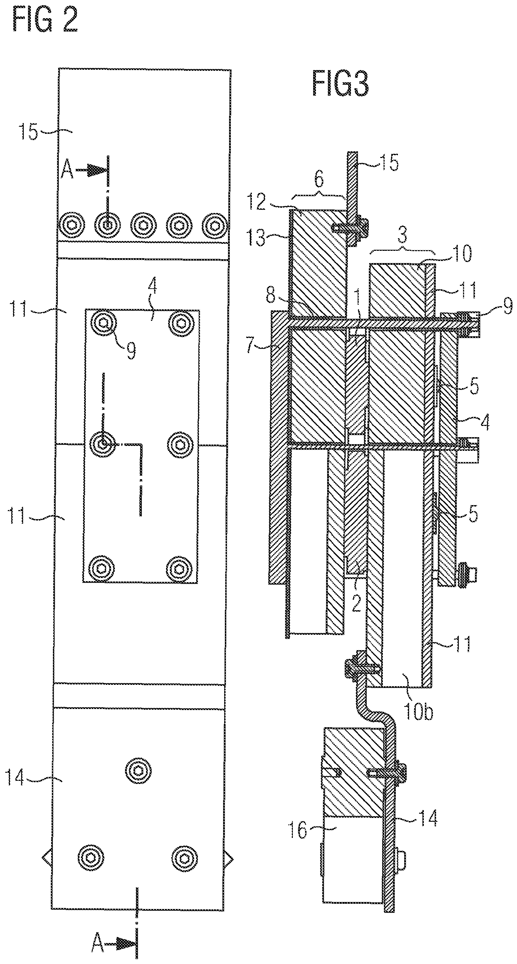

Fig. 2 zeigt die in Fig. 1 dargestellte Anordnung im montierten Zustand in einer Aufsicht. Dabei ist eine Schnittführung A-A der in Fig. 3 dargestellten Schnittdarstellung eingezeichnet.

In der Schnittdarstellung ist einer der Kühlkanäle 10b dargestellt, die durch die Abdeckplatte 11 auf den Längsrippen der einen Kühlanordnung 3 gebildet werden. Im Betrieb geben die Halbleiterbauelemente 1, 2 Wärme an die Kühlkörper 10, 12 ab, welche günstigerweise aus Aluminium gefertigt sind. In den Kühlkanälen wird der Großteil dieser Wärme an ein Kühlmedium, z.B. Luft, abgegeben. Die restliche Wärme wird über die sonstige Oberfläche der Kühlanordnung an die Umgebung abgegeben.

Die Montage der Kühlanordnung erfolgt beispielsweise mittels einer Presse, insbesondere einer Hydraulikpresse mit einstellbarer Druckkraft. Nach dem Zusammenfügen der einzelnen Teile, wobei die Halbleiterbauelemente 1, 2 und die Scheiben zur Bildung punktförmiger Auflagen 5 vorzugsweise mittels Schablonen auf gemeinsame Symmetrieachsen eingerichtet werden, erfolgt ein Verspannen der Kühlanordnung durch Aufbringen einer vorgegebenen Spannkraft mittels Presse. Im verspannten Zustand werden die Befestigungselemente 9 so lange angezogen, bis die Elemente der Kühlanordnung, größtenteils durch Verformung der ersten Druckplatte 4 und durch Dehnung der Zuganker 8, die Spannkraft aufbringen.

## Patentansprüche

1. Kühlanordnung, umfassend zwei nebeneinander angeordnete, scheibenförmige Halbleiterbauelemente (1, 2), insbesondere Thyristoren, mit zueinander ungefähr parallel ausgerichteten Symmetrieachsen, welche mittels nur einer Spannvorrichtung zwischen zwei Kühlkörpereinheiten (3, 6) gespannt sind, **dadurch gekennzeichnet, dass** die eine Kühlkörpereinheit (3) an der den Halbleiterbauelementen (1, 2) abgewandten Seite Längsrippen aufweist und im Bereich zwischen den beiden Halbleiterbauelementen (1, 2) einen Schlitz (10a) quer durch die Längrippen zur Schwächung des Querschnitts aufweist und dass die eine Kühlkörpereinheit (3) mit der den Halbleiterbauelementen (1, 2) abgewandten Seite über punktförmige Auflagen (5) im Bereich der Symmetrieachsen gegen eine erste Druckplatte (4) gedrückt ist, indem eine an die andere Kühlkörpereinheit (6) gekoppelte zweite Druckplatte (7) über Zuganker mit der ersten Druckplatte (4) verspannt ist.

2. Anordnung nach Anspruch 1, **dadurch gekennzeichnet, dass** der im Bereich zwischen den Halbleiterbauelementen vorgesehene Schlitz (10a) über die gesamte Rippenhöhe reicht.

3. Anordnung nach Anspruch 1 oder 2, **dadurch gekennzeichnet, dass** das die beiden Halbleiterbauelemente (1, 2) antiparallel geschaltet sind.

4. Anordnung nach einem der Ansprüche 1 bis 3, **dadurch gekennzeichnet, dass** die eine Kühlkörpereinheit (3) aus einem im Wesentlichen quaderförmigen Kühlkörper (10) mit Längsrippen und einer auf den Längrippen aufliegenden Abschlussplatte (11) gebildet ist und dass der Schlitz (10a) auch die Abschlussplatte (11) zweiteilt.

5. Anordnung nach einem der Ansprüche 1 bis 4, **dadurch gekennzeichnet, dass** auf der den Halbleiterbauelementen (1, 2) abgewandten Seite der einen Kühlkörpereinheit (3) im Bereich der beiden Symmetrieachsen Erhebungen, insbesondere Kugelkalotten, zur Bildung der punktförmigen Auflagen (5) angeordnet sind.

6. Anordnung nach einem der Ansprüche 1 bis 4, **dadurch gekenntzeichnet, dass** zwischen der einen Kühlkörpereinheit (3) und der ersten Druckplatte (4) im Bereich der beiden Symmetrieachsen jeweils eine Scheibe mit einer zentrischen Kugelkalotte zur Bildung der punktförmigen Auflagen (5) angeordnet ist.

7. Anordnung nach einem der Ansprüche 1 bis 6, **dadurch gekennzeichnet, dass** die andere Kühlkörpereinheit (6) und die zweite Druckplatte (7) einstückig ausgebildet sind.

8. Anordnung nach einem der Ansprüche 1 bis 7 **dadurch gekennzeichet, dass** die andere Kühlkörpereinheit (6) aus einem im wesentlichen quaderförmigen Kühlkörper (12) mit Längsrippen und einer auf den Längrippen aufliegenden Abschlussplatte (13) gebildet ist.

## Claims

1. Cooling arrangement, comprising two disc-shaped semiconductor elements (1, 2), in particular thyristors, disposed next to each other, with axes of symmetry aligned approximately in parallel with respect to one another, which are tensioned between two heat sink units (3, 6) by means of just one clamping apparatus,
**characterised in that** the one heat sink unit (3) has longitudinal ribs on the side facing away from the semiconductor elements (1, 2) and in the region between the two semiconductor elements (1, 2) has a slot (10a) straight through the longitudinal ribs for weakening the cross-section and that the one heat sink unit (3) is pressed against a first pressure plate (4) with its side facing away from the semiconductor elements (1, 2) via punctiform supports (5) in the region of the axes of symmetry, by a second pressure plate (7) coupled to the other heat sink unit (6) being clamped to the first pressure plate (4) via tension rods.

2. Arrangement according to claim 1, **characterised in that** the slot (10a) provided in the region between the semiconductor elements reaches across the entire height of the ribs.

3. Arrangement according to claim 1 or 2, **characterised in that** the two semiconductor elements (1, 2) are connected in anti-parallel.

4. Arrangement according to one of claims 1 to 3, **characterised in that** the one heat sink unit (3) is formed of an essentially square-shaped heat sink (10) with longitudinal ribs and a covering plate (11) resting against the longitudinal ribs and that the slot (10a) also divides the covering plate (11) into two.

5. Arrangement according to one of claims 1 to 4, **characterised in that** elevations, in particular spherical domes, are arranged on the side of the one heat sink unit (3) facing away from the semiconductor elements (1, 2) in the region of the two axes of symmetry to form the punctiform supports (5).

6. Arrangement according to one of claims 1 to 4, **characterised in that** one disc with a centric spherical dome is arranged between the one heat sink unit (3) and the first pressure plate (4) in the region of the two axes of symmetry in each case to form the punctiform supports (5).

7. Arrangement according to one of claims 1 to 6, **characterised in that** the other heat sink unit (6) and the second pressure plate (7) are embodied in one piece.

8. Arrangement according to one of claims 1 to 7, **characterised in that** the other heat sink unit (6) is formed of an essentially square-shaped heat sink (12) with longitudinal ribs and a covering plate (13) resting against the longitudinal ribs.

## Revendications

1. Dispositif de refroidissement comprenant deux composants à semi-conducteurs (1, 2) en forme de disques disposés à proximité l'un de l'autre, en particulier des thyristors, avec des axes de symétrie dirigés à peu près parallèlement l'un à l'autre, qui sont enserrés entre deux unités à corps de refroidissement (3, 6) par un seul dispositif de serrage, **caractérisé en ce que** l'une des unités à corps de refroidissement (3) comprend du côté opposé aux composants à semi-conducteurs (1, 2) des nervures longitudinales, et dans la zone comprise entre les deux composants à semi-conducteurs (1, 2) une fente (10a) transversale aux nervures longitudinales pour l'affaiblissement de la section transversale, et **en ce que** ladite une des unités à corps de refroidissement (3) est pressée contre une première plaque de pression (4), du côté opposé aux composants à semi-conducteurs (1, 2), par l'intermédiaire de surfaces d'appui ponctuelles (5) dans la zone des axes de symétrie, une seconde plaque de pression (7) accouplée à l'autre unité à corps de refroidissement (6) étant enserrée avec la première plaque de pression (4) par l'intermédiaire de tirants d'ancrage.

2. Dispositif selon la revendication 1, **caractérisé en ce que** la fente (10a) prévue dans la zone comprise entre les composants à semi-conducteurs s'étend sur toute la hauteur des nervures.

3. Dispositif selon la revendication 1 ou 2, **caractérisé en ce que** les deux composants à semi-conducteurs (1, 2) sont connectés en montage antiparallèle.

4. Dispositif selon l'une des revendications 1 à 3, **caractérisé en ce que** ladite une des unités à corps de refroidissement (3) est constituée d'un corps de refroidissement (10) de forme essentiellement parallélépipédique avec des nervures longitudinales, et d'une plaque de fermeture (11) reposant sur les nervures longitudinales, et **en ce que** la fente (10a) sépare également en deux la plaque de fermeture (11).

5. Dispositif selon l'une des revendications 1 à 4, **caractérisé en ce que,** sur le côté opposé aux composants à semi-conducteurs (1, 2) de ladite une des unités à corps de refroidissement (3), dans la zone des deux axes de symétrie, sont disposées des saillies, en particulier des calottes sphéroïdales, pour la constitution des surfaces d'appui ponctuelles (5).

6. Dispositif selon l'une des revendications 1 à 4, **caractérisé en ce qu**'entre ladite une des unités à corps de refroidissement (3) et la première plaque de pression (4), dans la zone des deux axes de symétrie, est disposée une rondelle avec une calotte centrale sphéroïdale pour la constitution des surfaces d'appui ponctuelles (5) respectives.

7. Dispositif selon l'une des revendications 1 à 6, **caractérisé en ce que** l'autre unité à corps de refroidissement (6) et la seconde plaque de pression (7) sont constituées d'une pièce.

8. Dispositif selon l'une des revendications 1 à 7, **caractérisé en ce que** l'autre unité à corps de refroidissement (6) est constituée d'un corps de refroidissement (12) de forme essentiellement parallélépipédique avec des nervures longitudinales, et d'une plaque de fermeture (13) reposant sur les nervures longitudinales.
